# EUROPEAN PATENT APPLICATION

(11) **EP 2 003 581 A1**
(43) Date of publication of application: **17.12.2008**
(21) Application number: 08010184.3
(22) Date of filing: 04.06.2008
(51) Int. Cl.: G06F 17/50, G01N 3/02

(54) **Structural analysis apparatus and structural analysis method**

(30) Priority: 15.06.2007 JP 2007158429
(71) Applicant: Toyota Jidosha Kabushiki Kaisha, Toyota-shi, Aichi-ken 471-8571 (JP)
(72) Inventor: Kumagai, Koushi, Toyota-shi Aichi-ken, 471-8571 (JP)
(74) Representative: Winter, Brandl, Fürniss, Hübner Röss, Kaiser, Polte Partnerschaft Patent- und Rechtsanwaltskanzlei

(57) **Abstract**

A structural analysis apparatus, including: state value calculation means (10) for calculating a state value of each of multiple elements constituting a model with which breakage of a structure is simulated; breakage determination means (11) for determining that an element among the multiple elements is broken when the state value of the element satisfies a breakage threshold condition that is set in advance for the element; crack face calculation means (11) for calculating a crack face (21) of the broken element that is determined to be broken by the breakage determination unit; and breakage threshold condition changing means (11) for changing a breakage threshold condition that is set for an element which is among the multiple elements, which is adjacent to the broken element, and which intersects with an extended face (22) of the crack face (21) of the broken element.

## Description

### BACKGROUND OF THE INVENTION

### 1. Field of the Invention

The invention relates generally to a computerized structural analysis technology, and, more specifically, to a technology for simulating breakage.

### 2. Description of the Related Art

Structural analysis methods, typified by a finite element method, are used to examine designs of various structures such as industrial products and architectural structures. For example, in an automobile design phase, deformation, breakage, stress state, etc. at the time of an automotive impact are simulated using a three-dimensional shaped model of a vehicle body, and the simulation result is used to examine the structure of the vehicle body.

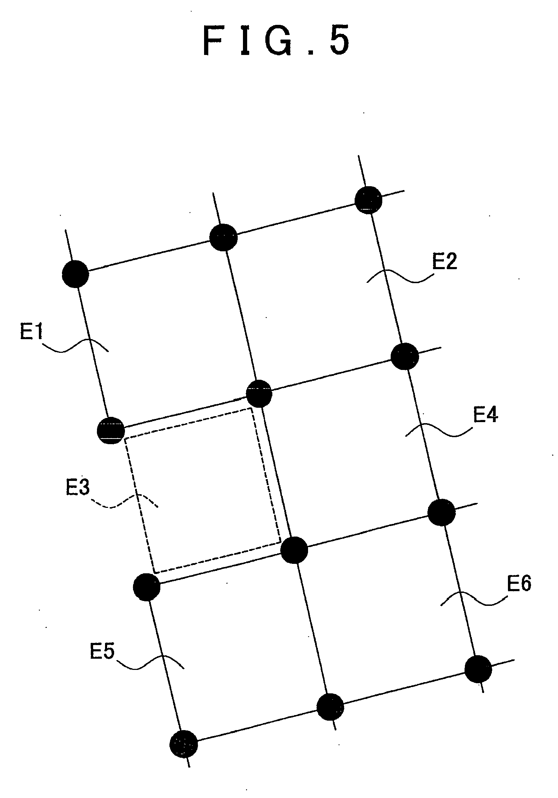

In a common finite element analysis, a breakage model as shown in FIG 5 is used to simulate breakage. In the breakage model shown in FIG 5, a breakage threshold is set in advance for each of elements E1 to E6. When the breakage threshold for an element among the elements E1 to E6 is reached, the element is erased (in an example shown in FIG 5, the element E3 is erased). With this breakage model, however, it is difficult to accurately simulate an actual breakage phenomenon.

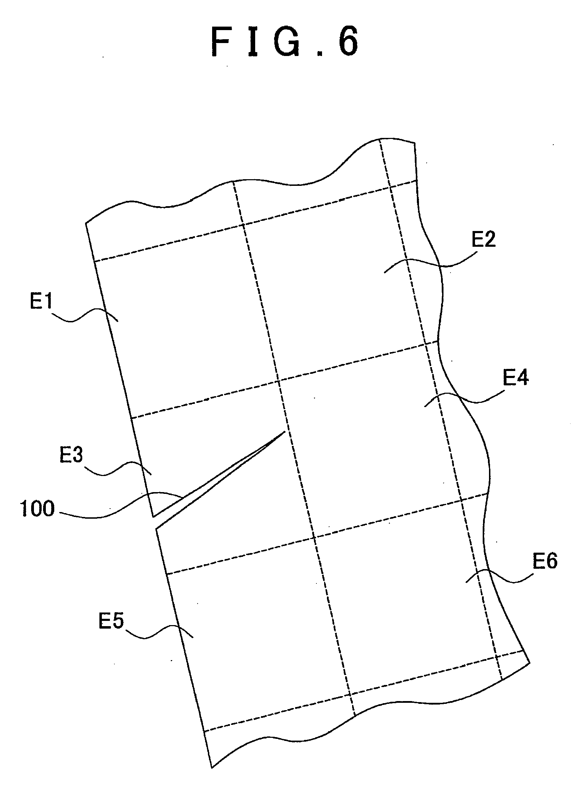

As shown in FIG. 6, in an actual breakage phenomenon, a sharp crack 100 occurs in a broken portion. Stress is concentrated on the tip of the crack 100. Therefore, a portion that is located in the direction in which the crack 100 develops, that is, a portion that is on an extension of the crack 100 (a portion that corresponds to the element E4) breaks more easily than the other portions. In contrast, in the breakage model shown in FIG 5, a recess is formed due to erasure of the element E3. However, the degree of stress concentration due to formation of the recess is considerably lower than that due to formation of a crack. Therefore, the element 4 is less likely to break in the breakage model in FIG. 5 than in an actual breakage phenomenon.

If the structure is divided into considerably small elements in a meshed pattern to significantly reduce the size of each element, it may be possible to simulate a crack and stress concentration on the tip of the crack. In this case, the problem described above does not occur. However, the structure needs to be divided into enormous number of elements; which increases time and cost for an analysis. Hence, there is a great demand for breakage models with which an actual breakage phenomenon is accurately simulated even if a structure is divided into relatively large-sized elements in a meshed pattern.

Japanese Patent Application Publication No. 11-272649 (JP-A-11-272649), Japanese Patent Application Publication No, 2001-34655 (JP-A-2001-34655), Japanese Patent Application Publication No. 2002-35986 (JP-A-2002-35986), and Japanese Patent Application Publication No. 2002-296163 (JP-A-2002-296163) describe methods for simulating breakage. JP-A-11-272649 describes a model formulating method for automatically dividing a shape having a crack into multiple elements in a meshed pattern. JP-A-2001-34655 describes a method for simulating crack propagation. According to the simulation method, a stress value is determined by a finite element computation, and a portion, which is located ahead of the crack, is updated by a crack propagation law. JP-A-2002-35986 describes a method for estimating, by a finite element method, a possible-crack occurrence portion in a structure, formed by connecting multiple panels to each other by spot-welding, based on a separation distance in the direction perpendicular to an estimation target face. JP-A-2002-296163 describes an impact analysis method for a molded resin product. According to the impact analysis method, the breakage determination condition for an element, which is adjacent to an element where the breakage determination condition is satisfied, is changed to a condition that corresponds to 10% to 80% of the original breakage determination condition.

### SUMMARY OF THE INVENTION

The invention provides a technology for making it possible to accurately simulate breakage of a structure without reducing a size of each element.

A first aspect of the invention relates to a structural analysis apparatus. The structural analysis apparatus includes: state value calculation means for calculating a state value of each of multiple elements constituting a model with which breakage of a structure is simulated; breakage determination means for determining that an element among the multiple elements is broken when the state value of the element satisfies a breakage threshold condition that is set in advance for the element; crack face calculation means for calculating a crack face of the broken element that is determined to be broken by the breakage determination means; and breakage threshold condition changing means for changing a breakage threshold condition that is set for an element which is among the multiple elements, which is adjacent to the broken element, and which intersects with an extended face of the crack face of the broken element.

In the first aspect of the invention, the breakage threshold condition changing means may change the breakage threshold condition for the element adjacent to the broken element so as to increase a likelihood that it is determined that the element adjacent to the broken element is broken.

In the first aspect of the invention, the breakage threshold condition may be used to define breakage threshold values for multiple directions, and the breakage threshold condition changing means may change the breakage threshold condition for the element adjacent to the broken element in such a manner that the breakage threshold value for a direction that is perpendicular to the crack face is lower than the threshold value for a direction that is parallel to the crack face.

In the first aspect of the invention, the breakage threshold condition may be defined in a form of a three-dimensional closed surface, and the closed surface may be reduced in a direction in which the breakage threshold value is decreased.

In the first aspect of the invention, the crack face calculation means may set the crack face to a face that is perpendicular to a main strain or a main stress, which is caused in the broken element.

In the first aspect of the invention, when a strain is used as the state value, a breakage threshold strain may be used as the breakage threshold condition.

In the first aspect of the invention, when a stress is used as the state value, a breakage threshold stress may be used as the breakage threshold condition.

In the first aspect of the invention, the breakage threshold condition changing means may change the breakage threshold condition that is set for a first element which is among the multiple elements, which is directly adjacent to the broken element and which intersects with the extended face of the crack face of the broken element, and the breakage threshold condition changing means may change the breakage threshold condition that is set for a second element which is among the multiple elements, which is adjacent to the first element and which intersects with the extended face of the crack face of the broken element.

In the first aspect of the invention, the breakage threshold condition changing means may change the breakage threshold conditions in such a manner that a likelihood that it is determined that the first element is broken is higher than a likelihood that it is determined that the second element is broken.

In the first aspect of the invention, the state value calculation means may calculate the state value of each of the elements using a finite element method.

The invention may be implemented as a structural analysis apparatus including at least part of the above-described means. Also, the invention may be implemented as a structural analysis method including at least part of the above-described steps, a structural analysis program based on which such structural analysis method is executed, or a computer-readable storage medium that stores the structural analysis program. The invention may be implemented by combining the above-described means together or combining the above-described steps together as much as possible.

A second aspect of the invention relates to a structural analysis method. According to the structural analysis method, a state value of each of multiple elements constituting a model with which breakage of a structure is simulated is calculated, and it is determined that an element among the multiple elements is broken when the state value of the element satisfies a breakage threshold condition that is set in advance for the element. Then, a crack face of the broken element that is determined to be broken is calculated, and a breakage threshold condition that is set for an element which is among the multiple elements, which is adjacent to the broken element, and which intersects with an extended face of the crack face of the broken element is changed.

In the second aspect of the invention, the breakage threshold condition that is set for a first element, which is among the multiple elements, which is directly adjacent to the broken element and which intersects with the extended face of the crack face of the broken element, may be changed, and the breakage threshold condition that is set for a second element, which is among the multiple elements, which is adjacent to the first element and which intersects with the extended face of the crack face of the broken element, may be changed.

A third aspect of the invention relates to a storage medium that stores a program based on which the structural analysis method according to the second aspect of the invention is executed.

According to the aspects of the invention described above, stress concentration due to formation of a crack is replaced with a change (adjustment) of the breakage threshold condition for the element that is adjacent to the broken element and that is present on the extension of the crack. Thus, it is possible to simulate the "likelihood of breakage" due to development of a crack. In addition, not the breakage threshold conditions for all the elements that are adjacent to the broken element but only the breakage threshold condition for the element that intersects with the extended face of the crack face is changed. Accordingly, it is possible to simulate the direction in which the crack develops. Further, the above-described aspects of the invention may be applied independently of the size of an element. Therefore, application of the above-described aspects of the invention does not incur increases in time and cost for analysis.

### BRIEF DESCRIPTION OF THE DRAWINGS

The foregoing and further features and advantages of the invention will become apparent from the following description of an example element with reference to the accompanying drawings, wherein the same or corresponding portions will be denoted by the same reference numerals and wherein:
FIG. 1 is a functional flock diagram illustrating the structure of a structural analysis apparatus according to an embodiment of the invention;
FIG 2 is a view showing a breakage model according to the embodiment of the invention;
FIG. 3 is a graph illustrating a breakage threshold condition according to the embodiment of the invention;
FIG. 4 is a flowchart according to the embodiment of the invention;
FIG 5 is a view showing a commonly-used breakage model; and
FIG 6 is a view showing an actual breakage phenomenon.

### DETAILED DESCRIPTION OF EXAMPLE EMBODIMENT

Hereafter, an example embodiment of the invention will be described with reference to the accompanying drawings.

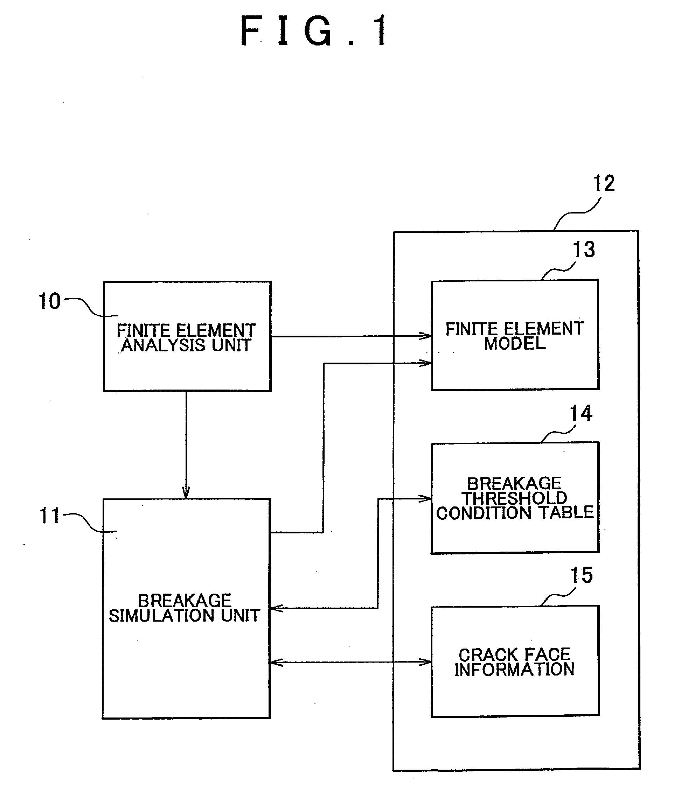

FIG. 1 is a functional block diagram illustrating the structure of a structural analysis apparatus according to an embodiment of the invention. The structural analysis apparatus analyzes, by a finite element method, deformation, breakage and stress state that are caused when a load is applied to a structure. The structural analysis apparatus is used for, for example, an automotive impact simulation.

The structural analysis apparatus includes a finite element analysis unit 10, a breakage simulation unit 11, and a storage unit 12, as main functional units. The storage unit 12 stores various data used for a structural analysis such as a finite element model 13, a breakage threshold condition table 14, and crack face information 15. The finite element analysis unit 10 has the function of calculating a state value (i.e., strain or stress) of each of elements that constitute the finite element model 13. The breakage simulation unit 11 has the function of simulating breakage of the element based on the result of calculation performed by the finite element analysis unit 10. These functions will be described later in detail.

The structural analysis apparatus may be formed of a general-purpose computer that includes some pieces of hardware such as a CPU (Central Processing Unit), a storage device (e.g. hard disc), an input unit (key board, pointing device), and a display unit. The functions and processing of the finite element analysis unit 10 and the breakage simulation unit 11 are implemented when the CPU executes the programs stored in the storage device. The storage unit 12 is a region that is reserved within the storage device when the programs are executed.

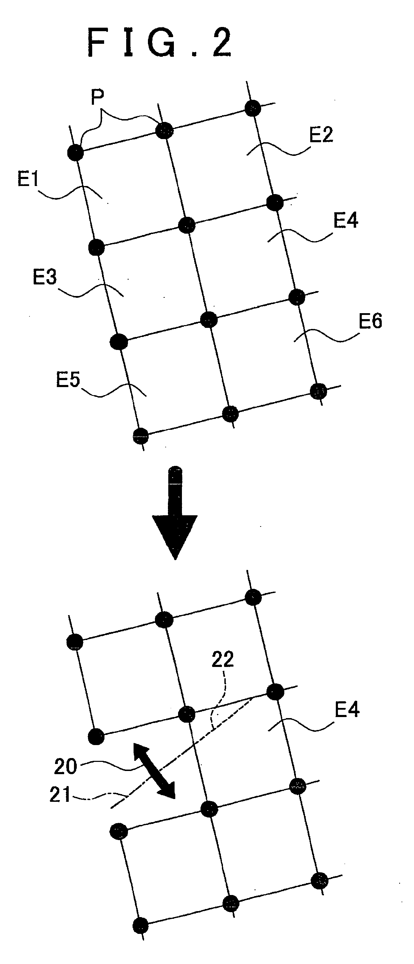

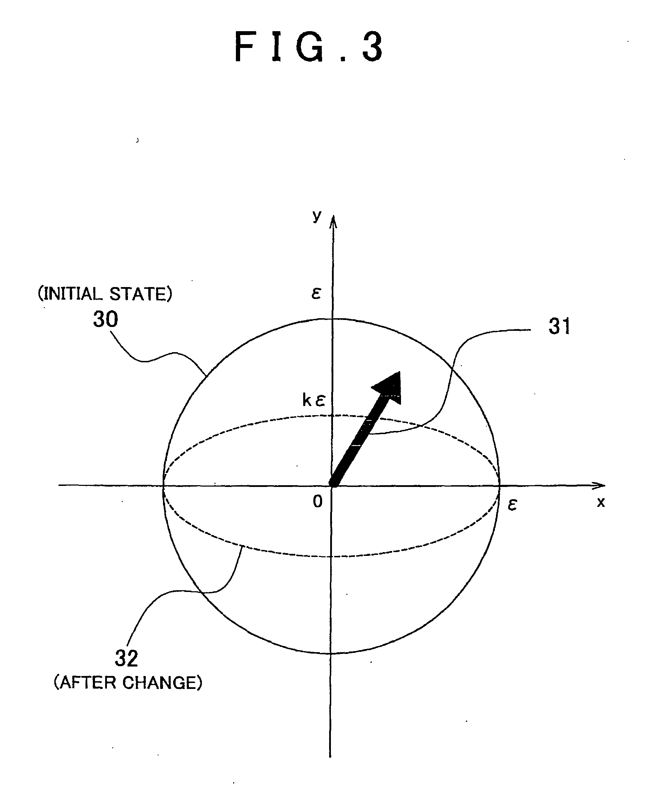

A breakage model (method for simulating breakage) used in the structural analysis apparatus according to the embodiment of the invention will be described with reference to FIGs. 2 and 3.

As shown in FIG. 2, in a finite element analysis, a three-dimensional structure (e.g. "vehicle body" in an automotive impact simulation) is expressed by the finite element model 13 that is formed of multiple elements E1 to E6. The elements E1 to E6 are connected (bound) to each other at nodes P. In FIG. 2, only square shell elements are shown for convenience of explanation. However, the breakage model according to the embodiment of the invention may be employed even if a shell element having a shape other than square or an element other than a shell element (e.g. beam element) is included in the finite element model.

A breakage threshold condition is set in advance for each of the elements E1 to E6. The breakage threshold condition is a parameter that is used to determine whether an element is broken. If a state value that is obtained as a result of a finite element analysis satisfies the breakage threshold condition that is set for an element, it is determined that the element is broken. The broken element is erased from the finite element model.

As a state value that is used to determine whether an element is broken, typically, "strain" or "stress" is used. However, instead of "strain" or "stress", any parameters that have causal relationship with breakage of an element may be used. Further, a combination of multiple types of parameters may be used as a state value.

For example, when strain is used as a state value, a breakage threshold value of strain (breakage threshold strain) is used as the breakage threshold condition. Then, whether an element is broken is determined by determining whether a main strain that occurs in the element has reached the breakage threshold strain. Because a main strain that occurs in an element may develop in any direction, preferably, a condition, based on which threshold values for multiple directions are determined, is used as the breakage threshold condition. Therefore, according to the embodiment of the invention, as shown in FIG. 3, a breakage threshold strain 30 is defined in the form of a three-dimensional closed surface, and whether the breakage threshold has been reached is determined by determining whether a main strain 31 intersects with the closed surface. Thus, it is possible to determine whether an element is broken, independently of the direction in which the main strain develops. In the initial state, the breakage threshold strain 30 is expressed in the form of a spherical surface, and therefore the threshold value is constant independently of the direction in which the main strain develops. Note that, the breakage threshold strain 30 is drawn two-dimensionally in FIG. 3 for convenience in illustration. However, the breakage threshold strain 30 is actually a three-dimensional element where the z-axis that extends in the direction perpendicular to the paper on which FIG. 3 is drawn is present.

The following description will be provided on the assumption that the element E3 is broken as shown in FIG 2. In an actual breakage phenomenon, a crack occurs in a portion of the element E3, and there is a considerably high possibility that the element E4 that is located at the tip of the crack will break due to stress concentration on the tip of the crack. In order to simulate this actual breakage phenomenon, in the breakage model according to the embodiment of the invention, the breakage threshold condition is changed (adjusted) in the following manner.

First, a crack face of the broken element E3 is determined. More specifically, a crack face 21 (indicated by an alternate long and short dash line in FIG. 2) is set to the face that is perpendicular to a main strain 20, which occurs when the element E3 breaks. In this case, the crack face is set so as to pass through the center of the broken element E3. However, the position of the crack face is not limited to this. For example, the crack face may be set so as to pass through the center of a side that includes a node that is displaced by a large amount. Alternatively, the crack face may be set so as to pass through the center of the gravity of the element E3, which is defined by assigning weights to displacements of the nodes.

Next, the element, which intersects with an extended face 22 (indicated by a dashed line in FIG. 2) of the crack face 21, is selected from the elements that are adjacent to the broken element E3. The extended face of the crack face means a face that is defined by extending the crack face and that is present on the side of the tip of the crack (a face that is defined by extending the crack face in the direction in which the crack develops). In the example shown in FIG. 2, the element 4 is selected. Then, the breakage threshold condition is eased as compared with the breakage threshold condition before change (i.e., the breakage threshold condition is changed so as to increase a likelihood that it is determined that the element 4 is broken).

At this time, preferably, an adjustment is made in such a manner that the breakage threshold value for the direction that is perpendicular to the crack face is set to a value lower than the threshold value for the direction that is parallel to the crack face, instead of a manner that the threshold values for all the directions are uniformly reduced. This is because the influence of stress concentration due to a crack is most obvious in the direction that is perpendicular to the crack face. Therefore, according to the embodiment of the invention, the breakage threshold strain is reduced in the direction that is perpendicular to the crack face, as shown by a dashed line 32 in FIG 3. In FIG 3, if the initial value of the breakage threshold strain is ε, the crack face is the x-z face, the direction that is perpendicular to the crack face is the y direction, and the reduction ratio of the breakage threshold strain is k, the breakage threshold strain after change is shown by an ellipse face that is expressed by the following equation. (x/ε)²+(y/kε)²+(z/ε)² = 1

If the breakage threshold strain is changed in the above-described manner, in the breakage simulation, the element 4 breaks more easily in the direction that is perpendicular to the direction in which the crack develops, as in an actual breakage phenomenon.

When "stress", instead of "strain" is used as a state value, a breakage threshold value of stress (breakage threshold stress) is used as the breakage threshold condition. Then, whether an element breaks is determined by determining whether a main stress caused in the element has reached the breakage threshold stress. Because the method for defining the breakage threshold stress and the method for adjusting the breakage threshold stress are similar to the method for defining the breakage threshold strain and the method for adjusting the breakage threshold strain shown in FIG. 3, the detailed description thereof will not be provided below.

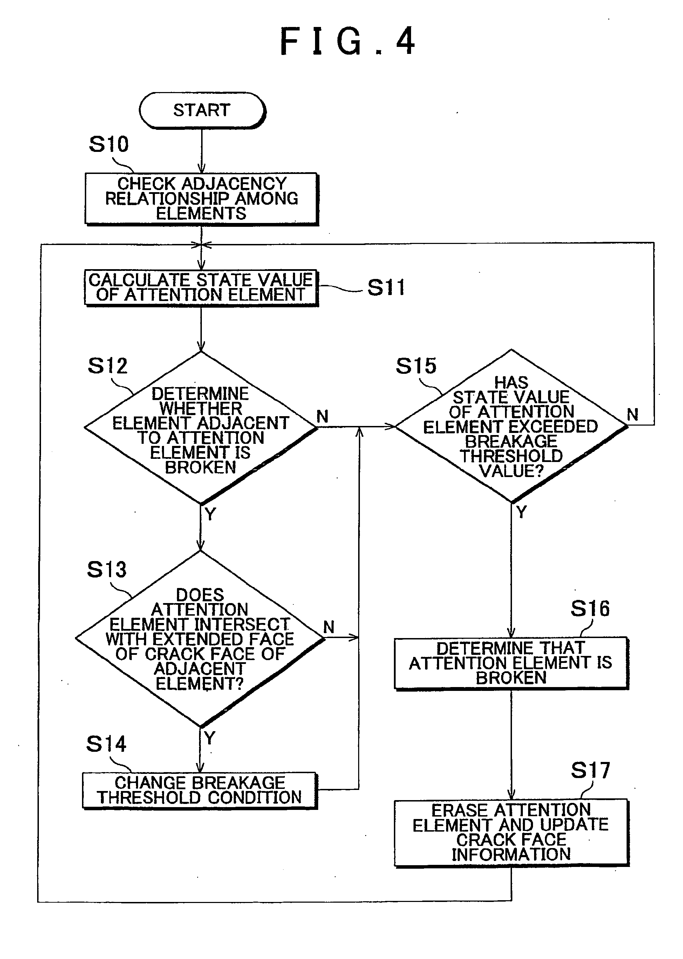

The routine for implementing the breakage model will be described with reference to a flowchart in FIG. 4. The description will be provided on the assumption that the finite element model 13 and the breakage threshold condition table 14 in which the initial value of the breakage threshold condition for each element is set are provided before the routine in the flowchart is executed. The flowchart shows the routine related to a specific attention element. In an actual program, the same routine is executed on each of all the elements.

In step (hereinafter, referred to as "S") 10, the breakage simulation unit 11 checks the adjacency relationship among the elements that constitute the finite element model 13. The numbers of the elements that are adjacent to an attention element are stored in the storage unit 12.

In S11, the finite element analysis unit 10 carries out a finite element analysis based on given conditions (e.g. magnitude of load, load input point, and flexibility) to calculate, for example, a state value (strain, stress) of the attention element.

In S12, the breakage simulation unit 11 determines whether the element adjacent to the attention element is broken. If it is determined that the adjacent element is not broken, S15 is executed. On the other hand, if it is determined that the adjacent element is broken, S13 is executed.

In S13, the breakage simulation unit 11 determines whether the attention element intersects with the extended face of the crack face of the element that is adjacent to the attention element. The presence or absence and the position of the crack face are determined with reference to the crack face information 15. If it is determined that the attention element does not intersect with the extended face of the crack face, there is no influence of the crack face on the attention element (or there is considerably small influence on the attention element). Therefore, S15 is executed. On the other hand, if it is determined that the attention element intersects with the extended face of the crack face, S14 is executed.

In S14, the breakage simulation unit 11 changes the breakage threshold condition for the attention element, and decreases the breakage threshold value for the direction that is perpendicular to the crack face. Then, S15 is executed.

In S15, the breakage simulation unit 11 determines whether the state value of the attention element, which is calculated in S11, has exceeded the breakage threshold value. If it is determined that the state value has exceeded the breakage threshold value, it is determined that the attention element is broken (S16). Then, the attention element is erased from the finite element model 13, the crack face of the broken attention element is determined, and the crack face information 15 stored in the storage unit 12 is updated (S17).

The above-described routine is executed on each of all the elements to simulate breakage. In the embodiment of the invention, the finite element analysis unit 10 corresponds to state value calculation means according to the invention, and the breakage simulation unit 11 corresponds to breakage determination means, crack face calculation means and breakage threshold condition changing means according to the invention.

With the breakage model according to the embodiment of the invention, stress concentration due to formation of a crack is replaced with a change in the breakage threshold condition for the adjacent element that is present on the extension of the crack. Thus, it is possible to simulate the "likelihood of breakage" due to development of a crack. In addition, not the breakage threshold conditions for all the elements that are adjacent to the broken element but only the breakage threshold condition for the element that intersects with the extended face of the crack face is changed. Accordingly, it is possible to simulate the direction in which the crack develops. Further, the above-described method is employed independently of the size of an element. Therefore, employment of the above-described method does not incur increases in time and cost for analysis.

While the invention has been described with reference to an example embodiment thereof, it is to be understood that the invention is not limited to the described embodiment or constructions. To the contrary, the invention is intended to cover various modifications and equivalent arrangements. In addition, while the various elements of the example embodiment are shown in various combinations and configurations, other combinations and configurations, including more, less ore only a single element, are also within the sprit and scope of the invention.

For example, in the flowchart in FIG. 4, the breakage threshold condition is changed (S12 to S14) between calculation of the state value of the attention element (S11) and determination whether the attention element is broken (S15 and S16). However, the breakage threshold condition may be changed after determination as to whether the attention element is broken is made. Namely, if it is determined that the attention element is broken, the crack face of the broken attention element is determined, the adjacent element that intersects with the extended face of the crack face is selected, and the breakage threshold condition for the adjacent element is changed. Thus, the process that corresponds to S12 and S13 is simplified. As a result, the routine is performed at a higher speed.

In the above description with reference to FIG 2, an element that intersects with the extended face 22 (indicated by the dashed line in FIG 2) of the crack face 21 is selected, and the breakage threshold condition for the element is eased as compared with the breakage threshold condition before change. However, an element, which is adjacent to the element that directly intersects with the extended face 22 of the crack face 21 and which also intersects with the extended face 22 of the crack face 21, may also be selected, and the breakage threshold condition for this element may be eased as compared with the breakage threshold condition before change. In this case, preferably, the breakage threshold condition for the element, which directly intersects with the extended face 22 of the crack face 21, and the breakage threshold condition for the element, which is adjacent to the element that directly intersects with the extended face 22 and which also intersects with the extended face 22 of the crack face 21, are set in such a manner that the likelihood that it is determined that the element, which directly intersects with the extended face 22, is broken is higher than the likelihood that it is determined that the element, which is adjacent to the element that directly intersects with the extended face 22, is broken. Note that, the breakage threshold condition for any number of elements that intersect with the extended face 22 of the crack face 21 may be changed.

In the embodiment of the invention described above, a finite element method is employed. However, the invention may be applied to a structural analysis method other than a finite element method.

## Claims

1. A structural analysis apparatus, **characterized by** comprising:
state value calculation means (10) for calculating a state value of each of multiple elements constituting a model with which breakage of a structure is simulated;
breakage determination means (11) for determining that an element among the multiple elements is broken when the state value of the element satisfies a breakage threshold condition that is set in advance for the element;
crack face calculation means (11) for calculating a crack face (21) of the broken element that is determined to be broken by the breakage determination means; and
breakage threshold condition changing means (11) for changing a breakage threshold condition that is set for an element which is among the multiple elements, which is adjacent to the broken element, and which intersects with an extended face (22) of the crack face (21) of the broken element.

2. The structural analysis apparatus according to claim 1, wherein the breakage threshold condition changing means (11) changes the breakage threshold condition for the element adjacent to the broken element so as to increase a likelihood that it is determined that the element adjacent to the broken element is broken.

3. The structural analysis apparatus according to claim 1 or 2, wherein:
the breakage threshold condition is used to define breakage threshold values for multiple directions, and
the breakage threshold condition changing means (11) changes the breakage threshold condition for the element adjacent to the broken element in such a manner that the breakage threshold value for a direction that is perpendicular to the crack face (21) is lower than the threshold value for a direction that is parallel to the crack face (21).

4. The structural analysis apparatus according to claim 3, wherein the breakage threshold condition is defined in a form of a three-dimensional closed surface (30, 32), and the closed surface is reduced in a direction in which the breakage threshold value is decreased.

5. The structural analysis apparatus according to any one of claims 1 to 4, wherein the crack face calculation means (11) sets the crack face (21) to a face that is perpendicular to a main strain (20) or a main stress, which is caused in the broken element.

6. The structural analysis apparatus according to any one of claims 1 to 5, wherein when a strain is used as the state value, a breakage threshold strain is used as the breakage threshold condition.

7. The structural analysis apparatus according to any one of claims 1 to 5, wherein when a stress is used as the state value, a breakage threshold stress is used as the breakage threshold condition.

8. The structural analysis apparatus according to any one of claims 1 to 7, wherein:
the breakage threshold condition changing means (11) changes the breakage threshold condition that is set for a first element which is among the multiple elements, which is directly adjacent to the broken element and which intersects with the extended face (22) of the crack face (21) of the broken element, and
the breakage threshold condition changing means (11) changes the breakage threshold condition that is set for a second element which is among the multiple elements, which is adjacent to the first element and which intersects with the extended face (22) of the crack face (21) of the broken element.

9. The structural analysis apparatus according to claim 8, wherein the breakage threshold condition changing means (11) changes the breakage threshold conditions in such a manner that a likelihood that it is determined that the first element is broken is higher than a likelihood that it is determined that the second element is broken.

10. The structural analysis apparatus according to any one of claims 1 to 9, wherein the state value calculation means (10) calculates the state value of each of the elements using a finite element method.

11. A structural analysis method, **characterized by** comprising:
calculating a state value of each of multiple elements constituting a model with which breakage of a structure is simulated;
determining that an element among the multiple elements is broken when the state value of the element satisfies a breakage threshold condition that is set in advance for the element;
calculating a crack face (21) of the broken element that is determined to be broken; and
changing a breakage threshold condition that is set for an element which is among the multiple elements, which is adjacent to the broken element, and which intersects with an extended face (22) of the crack face (21) of the broken element.

12. The structural analysis method according to claim 11, wherein
the breakage threshold condition that is set for a first element, which is among the multiple elements, which is directly adjacent to the broken element and which intersects with the extended face (22) of the crack face (21) of the broken element, is changed, and
the breakage threshold condition that is set for a second element, which is among the multiple elements, which is adjacent to the first element and which intersects with the extended face (22) of the crack face (21) of the broken element, is changed.

13. A storage medium that stores a program based on which the structural analysis method according to claim 11 or 12 is executed.
